# EUROPEAN PATENT SPECIFICATION

(11) **EP 0 664 617 B1**
(45) Date of publication and mention of the grant of the patent: **22.10.1997**
(21) Application number: 95300232.6
(22) Date of filing: 13.01.1995
(51) Int. Cl.: H03L 7/183, H03L 7/107

(54) **PLL synthesizer**
PLL-Synthetisierer
Synthétiseur à PLL

(30) Priority: 19.01.1994 JP 4180/94
(43) Date of publication of application: 26.07.1995
(73) Proprietor: JAPAN RADIO CO., LTD, Mitaka-shi Tokyo 181 (JP)
(72) Inventor: Yamashita, Kazuo, c/o Japan Radio Co., Ltd., Mitaka-shi, Tokyo 181 (JP); Inoue, Akiharu, c/o Japan Radio Co., Ltd., Mitaka-shi, Tokyo 181 (JP); Egawa, Masahiko, c/o Japan Radio Co., Ltd., Mitaka-shi, Tokyo 181 (JP); Sakuma, Hiroaki, c/o Japan Radio Co., Ltd., Mitaka-shi, Tokyo 181 (JP); Adachi, Nobuyuki, c/o Japan Radio Co., Ltd., Mitaka-shi, Tokyo 181 (JP)
(74) Representative: Cross, Rupert Edward Blount

(56) References cited:
- EP-A- 0 211 594
- EP-A- 0 461 358
- EP-A- 0 610 995
- US-A- 3 729 688
- US-A- 4 752 749
- US-A- 4 937 536

## Description

### BACKGROUND OF THE INVENTION

### Field of the Invention

The present invention relates to a PLL (Phase Locked Loop) synthesizer which is used for a press-to-talk wireless installation, a digital cellular telephone, a digital cordless telephone, etc., and a method of controlling such a PLL synthesizer.

### Description of the Prior Art

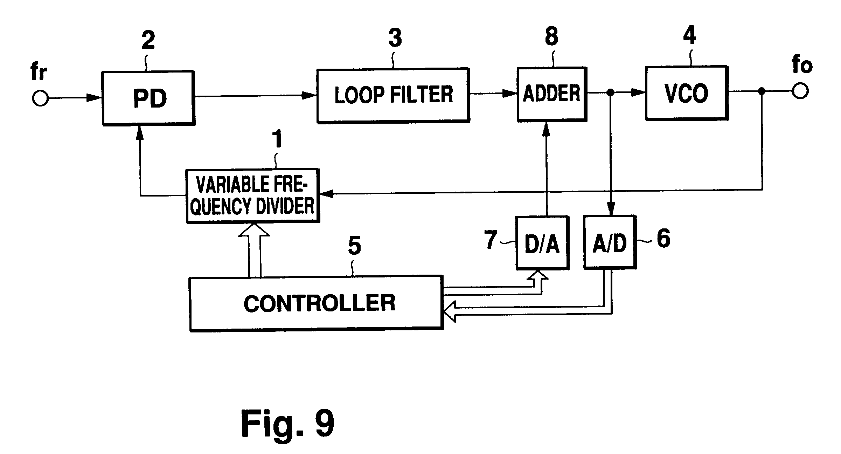

A PLL synthesizer having a structure such as that shown in Fig. 9 is conventionally known. Fig. 9 schematically shows the structure of, for example, a "Hi-speed Digital Loop-Preset (DLP) Frequency Synthesizer", Yoshiaki TARUSAWA, and Yasushi YAMAO, NTT Radio Communication Systems Laboratories, which is described in The Reports of Technical Researches of the Institute of Electronics and Communication Engineers of Japan, 1989 Autumn B-545, pp 2-215.

In this structure, the PLL is composed of a variable frequency divider 1, a phase detector (PD) 2, a loop filter 3 and a voltage controlled oscillator (VCO) 4. The VCO 4 oscillates at an output frequency f₀ which is dependent upon the control voltage supplied from the PD 2 via the loop filter 3 and the adder 8. The VCO 4 supplies the oscillated signal to a circuit (not shown) at a subsequent stage. The output frequency f₀ produced by the VCO 4 is divided by the variable frequency divider 1 and the divided frequency is supplied to the PD 2.

It is possible to set the frequency division ratio down to a value smaller than one. If it is assumed that the frequency division ratio is n, the frequency supplied from the variable frequency divider 1 to the PD 2 is f₀/n. The PD 2 compares the frequency of the signal supplied from the variable frequency divider 1 with a reference frequency fᵣ which is the reference of the output frequency f₀. In other words, the PD 2 detects the phase and produces a control voltage of the VCO 4 on the basis of the result of the detection. The loop filter 3 provided at the subsequent stage to the PD 2 has a time constant which is necessary for stabilizing the output frequency f₀ of the PLL. The control voltage produced by the PD 2 is supplied to the VCO 4 via the loop filter 3. In this way, the output frequency f₀ is so controlled as to have the value n times as large as the reference frequency fᵣ.

In the structure shown in Fig. 9, a controller 5, an A/D converter 6, a D/A converter 7 and an adder 8 are further provided. The controller 5 digitally sets the frequency division ratio n of the variable frequency divider 1 in correspondence with the required output frequency f₀. That is, the PLL shown in Fig. 9 serves as the DLP (Digital Loop Preset). The controller 5 uses the A/D converter 6, the D/A converter and the adder 8 in order to switch the output frequency f₀.

The control voltage of the VCO 4 is first converted into a digital value by the A/D converter 6. The digital control voltage is stored in the controller 5. These processings are executed in advance with respect to various output frequencies f₀. In order to switch the output frequency f₀ to a different output frequency f₀, the controller 5 takes out the control voltage which corresponds to the necessary output frequency f₀. The D/A converter 7 converts the control voltage taken out by the controller 5 into an analog signal and supplies it to the adder 8. Simultaneously, the controller 5 resets the variable frequency divider 1.

According to the structure shown in Fig. 9, the PLL synthesizer which is capable of switching the output frequency f₀ at high speed is realized. For example, the PLL synthesizer can shorten the time required for switching the output frequency f₀ in a hands off mode or with the roaming of the zone of mobile communication, and it is suitable for a band of 1.5 GHz.

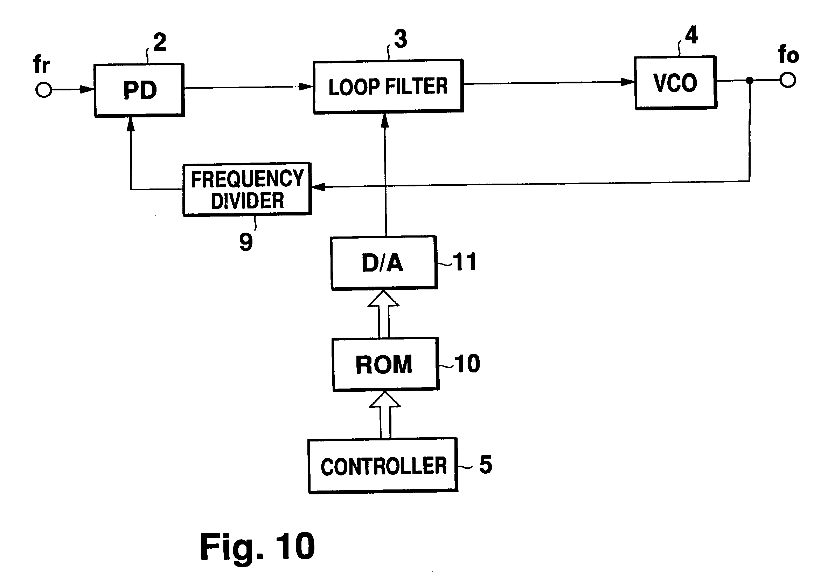

Fig. 10 schematically shows the structure of a PLL synthesizer such as "Frequency Synthesizer with Short Switching time for Digital Mobile Radio Communication", Toshimitsu KIBAYASHI, Yoshifumi TODA and Susumu SASAKI, Fujitsu Limited, which is described in The Reports of Technical Researches of the Institute of Electronics and Communication Engineers of Japan, 1990 Autumn B-308, pp 2-308. In Fig. 10, the drawing is simplified in order to clarify the difference between the prior art and the present invention.

The PLL synthesizer shown in Fig. 10 is composed of a frequency divider 9, a PD 2, a loop filter 3 and a VCO 4. The time constant of the loop filter 3 is set by using a controller 5, a ROM 10 and a D/A converter 11.

When the output frequency f₀ of the VCO 4 is switched, the controller 5 controls the read-out operation of the ROM 10 such that the data corresponding to the output frequency f₀ is output from the ROM 10. The D/A converter 11 converts the data into an analog signal and supplies the signal to the loop filter 3. The time constant of the loop filter 3 is determined by a capacitor (not shown) provided therein, and the capacitor is charged by the output of the D/A converter 11.

According to this structure, it is possible to switch the control voltage of the VCO 4 at high speed and, hence, to change the output frequency f₀ to the required output frequency f₀ at high speed. For example, it is possible to change the output frequency f₀ from 1387 MHz to 1412 MHz within 2 m sec.

As described above, various methods of enhancing the speed of switching the output frequency f₀ in a PLL synthesizer have conventionally been proposed. These methods, however, require an A/D converter and/or a D/A converter having a high accuracy, so that the circuit structure is complicated.

For example, the case of using the circuit structure shown in Fig. 9 or 10 in a local oscillator for quadrature phase shift keying (QPSK) demodulation will be considered. If the output of the reference oscillator is input as the reference frequency fᵣ, in order to enable digital QPSK demodulation while switching the output frequencies f₀ with a difference of about 15 MHz, it is necessary to converge (stabilize) the output frequency f₀ on the target frequency with an error of less than about 200 Hz in about 1 msec.

In order to stabilize the output frequency f₀ in about 1 m sec in the structure shown in Fig. 9, the error of the frequency output from the variable frequency divider 1 must be not more than 4 kHz, and the digital data which shows the frequency division ratio n supplied from the controller 5 to the variable frequency divider 1 is required to have an accuracy high enough to realize the stabilization. That is, in order to switch the frequencies with a difference of about 15 MHz, the A/D converter 6 and the D/A converter 7 are required to have an accuracy of not less than 12 bits.

In the structure shown in Fig. 10, in order to switch the frequencies with a difference of about 15 MHz in about 1 msec with an error of less than about 200 Hz, the D/A converter 11 is required to have accuracy of not less than 17 bits. In addition, in the structure shown in Fig. 10, since the capacitor of the loop filter 3 is charged by the output of the D/A converter 11, the charges of the capacitor are lost in the circuit at the subsequent stage before the end of the frequency changing, so that there is a limitation to high-speed frequency changing.

As a method of switching the output frequency f₀ at high speed without using the D/A converter or the A/D converter having such a high accuracy, for example, a method of using two PLLs is put to practical use. In this method, one of the PLLs is used for producing the output frequency f₀ at the present time and the other PLL prepares the output frequency f₀ for the next time. However, this method, which requires a circuit twice as large as the circuit required in the method of using only one PLL, is disadvantageous from a point of view of reduction in the size of the circuit, the cost and the power consumption.

US-A-4,937,536 discloses a phase lock loop frequency synthesizer for providing a synthesized frequency signal employing a modified adaptive loop construction having parallel feedback paths about a loop amplifier. A normal feedback path having a narrow bandwidth characteristic includes a feedback capacitor having one end connected to electrical ground via a controlled switch and a second feedback path having a wide bandwidth characteristic with a capacitor also connected across the amplifier. Upon the variation of an incoming reference signal, the controlled switch connects the normal feedback capacitor to ground permitting the wide bandwidth feedback path to rapidly settle the loop while charging the feedback capacitor of the normal feedback path. Upon opening the controlled switch, the narrow bandwidth feedback path completes the charging of the feedback capacitor of the normal feedback loop settling the loop to the steady state condition while enhancing the settling time.

US-A-4,752,749 discloses a lag network for eliminating frequency disturbances caused by voltage fluctuations which occur when the bandwidth limiting lag network is switched in and out of a frequency synthesizer circuit to provide the wide bandwidth necessary for fast frequency hopping. Rather than switching a parallel charging source for the lag network capacitor out of the circuit during each hopping interval, the capacitor is charged in series to a constant level during narrow bandwidth mode and charged on both plates in consonance with the input voltage during the wide bandwidth mode to thereby render the lag network active during the narrowband mode and transparent during the wideband mode.

### SUMMARY OF THE INVENTION

Accordingly, it is a first object for particular embodiments of the invention to eliminate the above-described problems in the prior art and to enable high-speed switching of output frequencies without using a plurality of PLLs, thereby realizing a reduction in the size of the circuit, the cost and the power consumption.

It is a second object for particular embodiments to enable high-speed switching of output frequencies without using a D/A converter or an A/D converter having high accuracy, thereby simplifying the circuit structure.

It is a third object for particular embodiments to stabilize the output frequency at a speed which is appropriate for, for example, digital QPSK demodulation.

It is a fourth object for particular embodiments to suppress a spurious output frequency produced after switching the frequencies due to an error of the reference frequency of the PLL or the slip frequency generated due to division with a ratio down to a value smaller than one.

To achieve these objects, in a first aspect of the present invention, there is provided a PLL synthesizer comprising: an oscillator for oscillating at an output frequency which depends upon a control voltage supplied thereto; a frequency divider for dividing the output frequency in correspondence with a required output frequency; a detector for detecting a phase of a frequency-divided output frequency by referring to a reference frequency which is the reference of the output frequency so as to produce the control voltage; and a loop filter for stabilizing the output frequency by filtering the control voltage produced by the detector and supplying a filtered control voltage to the oscillator, the loop filter including:
a high-speed time constant circuit constantly inserted between the detector and the oscillator and having a predetermined first time constant so set that when the required output frequency is changed, the output frequency produced by the oscillator is stepwisely changed to a new output frequency at high speed;
a low-speed time constant circuit including a capacitor, the low-speed time constant circuit being inserted between the detector and the oscillator as occasion demands and having a predetermined second time constant so set that a spurious output frequency produced due to an error of the reference frequency or an error of the frequency-divided output frequency is suppressed when the low-speed time constant circuit is inserted between the detector and the oscillator; and
switching means for making and breaking a signal path between the detector and the oscillator via the low-speed time constant circuit as occasion demands,
characterised in that:
while the low-speed time constant circuit is not inserted between the detector and the oscillator, the capacitor holds a voltage indicative of the frequency at which the oscillator was oscillating when the low-speed time constant circuit was last inserted between the detector and the oscillator.

According to a second aspect of the present invention there is provided a PLL synthesizer for providing a plurality of output frequencies, the plurality of output frequencies including at least first and second frequencies, the synthesizer further comprising:
a plurality of circuits arranged in parallel, each circuit comprising a low-speed time constant circuit in series with switching means, each circuit being provided in correspondence with a respective one of the plurality of output frequencies. The PLL synthesizer further comprises a controller for controlling the frequency divider and the switching means in accordance with a predetermined processing,
the controller including:
   means for switching the output frequency from the first frequency to the second frequency by controlling the frequency divider;
   means for breaking the signal path between the detector and the oscillator via the low-speed time constant circuit which corresponds to the first frequency by controlling the switching means which corresponds to the first frequency when the output frequency is to be switched from the first frequency to the second frequency; and
   means for making the signal path between the detector and the oscillator via the low-speed time constant circuit which corresponds to the second frequency by controlling the switching means which corresponds to the second frequency after the output frequency is changed in a stepwise manner to the second frequency.

In a third aspect of the present invention, there is provided a PLL synthesizer similar to that provided in the first aspect and further comprising a controller for controlling the frequency divider and the switching means in accordance with predetermined processing, the controller including:
means for switching a frequency division ratio of the frequency divider to the value which corresponds to a temporary frequency when the output frequency is to be temporarily switched from a communication frequency to the temporary frequency;
means for switching the time constant of the loop filter to a value smaller than a usual value by controlling the switching means when the output frequency is to be temporarily switched from the communication frequency to the temporary frequency;
means for switching the frequency division ratio of the frequency divider to a value which corresponds to the communication frequency when the output frequency is to be returned to the communication frequency; and
means for switching the time constant of the loop filter to a value which corresponds to the communication frequency and which is suitable for suppressing a spurious output frequency by controlling the switching means after the output frequency is returned to the communication frequency.

In the PLL synthesizers provided in the first to third aspects of the present invention, it is possible to switch the time constant of the loop filter between a time constant which is comparatively small and a time constant which is comparatively large. More specifically, when only the high-speed time constant circuit is inserted between the detector and the oscillator, the time constant of the loop filter becomes a comparatively small time constant which is determined only by that of the high-speed time constant circuit. In this state, if the frequency division ratio of the frequency divider is set in correspondence with the required output frequency so as to switch the output frequency of the oscillator, the output frequency of the oscillator is changed in a stepwise manner to a new frequency at high speed. On the other hand, when the low-speed time constant circuit is inserted between the detector and the oscillator by the operation of the switching means, the time constant of the loop filter becomes a comparatively large time constant which is mainly determined by the low-speed time constant circuit. In this state, the time constant of the loop filter is too large to change the output frequency at high speed. However, by utilizing the low-speed time constant circuit, it is possible to suppress a spurious output frequency produced due to an error of the reference frequency which is supplied to the detector or an error of the frequency division of the frequency divider (e.g., slip frequency due to the division by a ratio with a value smaller than one).

For example, when a PLL synthesizer is used for a local oscillator of a wireless installation (e.g., press-to-talk wireless installation, stations of a digital mobile telephone system and those of a digital cordless telephone system) in which the transmitted frequency is different from the received frequency, to use the installation, there is a method of A) switching the output frequencies of the PLL synthesizer between the frequencies which correspond to the transmitted frequency and the received frequency, and B) a method of dealing with the difference between the transmitted frequency and the received frequency using external equipment without switching the output frequency throughout the transmission and reception.

In the case of adopting the method A), the PLL synthesizer provided in any of the first to third aspects of the present invention can be utilized for high-speed frequency changing or the suppression of a spurious output frequency at the time of switching between the transmitted frequency and the received frequency.

According to the PLL synthesizer provided in the second aspect of the present invention, at the time of switching the output frequency of the oscillator (e.g., VCO) constituting the PLL synthesizer from the first frequency to the second frequency, the frequency division ratio of the frequency divider is changed from the value which corresponds to the first frequency to the value which corresponds to the second frequency, and the signal path via the low-speed time constant circuit which corresponds to the first frequency is broken by the control of the switching means. By this operation, the time constant of the loop filter becomes a value which is suitable for high-speed frequency changing, thereby changing the frequency to the second frequency at high speed.

In addition, according to the PLL synthesizer provided in the second aspect of the present invention, after the output frequency is changed to the second frequency, the controller produces a signal path via the low-speed time constant circuit which corresponds to the second frequency. When the low-speed time constant circuit is inserted between the detector and the oscillator, it suppresses the production of a spurious output frequency due to an error of the reference frequency and/or an error of the frequency division of the frequency divider. Therefore, the production of a spurious output frequency, after the end of frequency changing, is suppressed. The number of the low-speed time constant circuits is not restricted to two.

Even if the method B) of not switching the output frequency through the transmission and reception is adopted when using the PLL synthesizer, the PLL synthesizer provided in the third aspect of the present invention is useful. For example, in a system adopting a TDMA (Time Division Multiple Access) system represented by a a mobile telephone system such as PDC in Japan and TIA in USA and a digital cordless telephone system such as PHS (Personal Handiphone System) in Japan, while signals are transmitted or received by using a predetermined frequency channel, the carrier sensing is carried out at a predetermined time (in a time slot in which neither transmission nor reception is conducted) so as to judge whether or not a signal at a significant level exists in other frequency channels. In the PLL synthesizer used for such applications, the output frequency of the PLL synthesizer used as the local oscillator is not switched at the time of switching from transmission to reception and vice versa, but it is switched when the operation is shifted from the transmission or the reception to the carrier sensing. Particular embodiments of the present invention are applicable to this switching. Adoption of these embodiments heightens the speed of changing the frequency to the frequency which is to be the object of monitoring and suppresses a spurious output frequency which may be produced when the frequency is returned to the transmitted or received frequency. In the PLL synthesizer used for this purpose, since the frequency which is to be the object of monitoring is not used for communication, there is no problem of producing a spurious output frequency at this frequency. Accordingly, one low-speed time constant circuit suffices.

As described above, according to particular embodiments of the invention, it is possible to produce a PLL synthesizer which is suitable for monitoring other frequency channels or switching of the output frequency without the need for an A/D converter and/or a D/A converter having a high accuracy. It is possible to heighten the speed of frequency switching by using a high-speed time constant circuit and suppressing a spurious output frequency after switching the frequency by using a low-speed time constant circuit. For example, even if the output frequencies are switched with a difference of about 15 MHz, it is possible to stabilize the output frequency f₀ with an error of less than about 200 Hz in about 1 msec, thereby favorably enabling digital QPSK demodulation. In addition, the production of a spurious output frequency due to the error of the reference frequency supplied to the PLL or the slip frequency due to the division to a ratio with a value smaller than one is favorably suppressed. As a result, it is possible to produce a PLL synthesizer which is suitable for a press-to-talk wireless installation, a digital cellular telephone, a digital cordless telephone, etc., and which has a small size at a low cost.

The low-speed time constant circuit may be composed of a resistor and a capacitor connected in series. In the low-speed time constant circuit having this structure, a spurious output frequency is suppressed by the charges stored in the capacitor. Since the capacitor is kept charged by breaking the signal path via the low-speed time constant circuit, the voltage of the capacitor is held by until the signal path via the low-speed time constant circuit is completed later. Therefore, the high-frequency component of the output of the detector which causes a spurious output frequency is absorbed by the capacitor -without producing a fluctuation in the output frequency. When a plurality of low-speed time constant circuits are prepared, at least one part of the resistors which constitute respective low-speed time constant circuits may be shared by other low-speed time constant circuits. In this manner, the structure of the apparatus may be simplified.

In a fourth aspect of the present invention, there is provided a controlling apparatus comprising:
a) means for switching a frequency division ratio of a frequency divider to a value which corresponds to a second frequency when an output frequency is to be switched from a first frequency to the second frequency;
b) means for switching a time constant of a loop filter from a value which corresponds to the first frequency and which is suitable for suppressing a spurious output frequency to a value which is suitable for high-speed frequency changing when the output frequency is to be switched from the first frequency to the second frequency; and
c) means for switching the time constant of the loop filter from the value which is suitable for the high-speed frequency changing to a value which corresponds to the second frequency and which is suitable for suppressing the spurious output frequency.

In a fifth aspect of the present invention, there is provided a controlling apparatus comprising:
a) means for switching a frequency division ratio of a frequency divider to a value which corresponds to a temporary frequency when an output frequency is to be switched from a communication frequency to the temporary frequency;
b) means for switching a time constant of a loop filter to a value smaller than a usual value when the output frequency is to be switched from the communication frequency to the temporary frequency;
c) means for switching the frequency division ratio of the frequency divider to a value which corresponds to the communication frequency when the output frequency is returned to the communication frequency; and
d) means for switching the time constant of the loop filter to the value which corresponds to the communication frequency and which is suitable for suppressing a spurious output frequency after the output frequency is returned to the communication frequency.

In a sixth aspect of the present invention, there is provided a controlling method comprising the steps of:
a) switching a frequency division ratio of a frequency divider to a value which corresponds to a second frequency when an output frequency is to be switched from a first frequency to the second frequency;
b) switching a time constant of a loop filter from a value which corresponds to the first frequency and which is suitable for suppressing a spurious output frequency to a value which is suitable for high-speed frequency changing when the output frequency is to be switched from the first frequency to the second frequency; and
c) switching the time constant of the loop filter from the value which is suitable for the high-speed frequency changing to a value which corresponds to the second frequency and which is suitable for suppressing the spurious output frequency after the output frequency is changed to the second frequency.

In a seventh aspect of the present invention, there is provided a controlling method comprising the steps of:
a) switching a frequency division ratio of a frequency divider to a value which corresponds to a temporary frequency when an output frequency is switched from a communication frequency to the temporary frequency;
b) switching a time constant of a loop filter to a value smaller than a usual value when the output frequency is to be switched from the communication frequency to the temporary frequency;
c) switching a frequency division ratio of the frequency divider to a value which corresponds to the communication frequency when the output frequency is to be returned to the communication frequency; and
d) switching the time constant of the loop filter to a value which corresponds to the communication frequency and which is suitable for suppressing a spurious output frequency after the output frequency is returned to the communication frequency.

The controlling apparatus and the controlling method provided in the fourth and sixth aspects of the present invention are suitable for embodying the second aspect of the present invention, and the controlling apparatus and the controlling method provided in the fifth and seventh aspects of the present invention are suitable for embodying the third aspect of the present invention.

The above and other objects, features and advantages of the present invention will become clear from the following description of the preferred embodiments thereof, taken in conjunction with the accompanying single drawing.

### BRIEF DESCRIPTION OF THE DRAWINGS

Fig. 1 is a block diagram schematically showing the structure of first and second embodiments of a PLL synthesizer according to the present invention;
Fig. 2 is a circuit diagram showing the structure of the main part, particularly, the inner part of the loop filter of the first embodiment of the present invention;
Fig. 3 is a timing chart showing the frequency stabilizing speed when a frequency is switched while the switch Sa is held ON;
Fig. 4 is a timing chart showing the frequency stabilizing speed when a frequency is switched while controlling the switches Sa and Sb;
Fig. 5 is a flow chart of the controlling process when the frequency is switched from fₐ to f_{b};
Fig. 6 is a flow chart of the controlling process when the frequency is switched from f_{b} to fₐ;
Fig. 7 is a flow chart of the controlling process when the frequency is monitored;
Fig. 8 is a circuit diagram showing the structure of the main part, particularly, the inner part of the loop filter of the second embodiment of the present invention;
Fig. 9 is a block diagram schematically showing the structure of a conventional PLL synthesizer; and
Fig. 10 is a block diagram schematically showing the structure of another conventional PLL synthesizer.

### DESCRIPTION OF THE PREFERRED EMBODIMENT

The preferred embodiment of the present invention will now be explained in more detail with reference to the accompanying drawings. The same reference numerals are provided for the elements which are the same as those in the prior art shown in Fig. 9 and 10, and explanation thereof will be omitted.

### a) Overall structure of a first embodiment

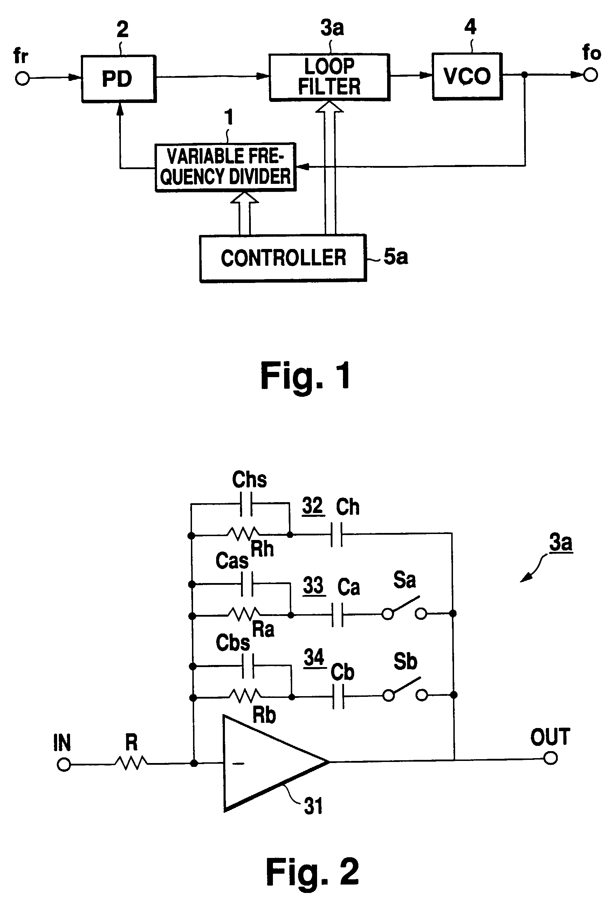

Fig. 1 schematically shows the structure of a first embodiment of a PLL synthesizer according to the present invention. In this structure, the PLL is composed of a variable frequency divider 1, a PD 2, a loop filter 3a and a VCO 4. A controller 5a digitally controls the frequency division ratio of the variable frequency divider 1 down to a value smaller than one. That is, the PLL synthesizer shown in Fig. 1 serves as a kind of DLP synthesizer. The controller 5a enables the switching of the output frequency f₀ at high speed and favorably suppresses a spurious output frequency by switching the switch provided in the loop filter 3a.

### b) Structure of the loop filter 3a in the first embodiment

Fig. 2 shows the structure of the loop filter 3a in this embodiment. The loop filter 3a is composed of an operational amplifier 31, a high-speed time constant circuit 32, and low-speed time constant circuits 33, 34.

The high-speed time constant circuit 32 is composed of resistors R, Rₕ, and capacitors Cₕₛ, Cₕ. The resistor R is provided between the input terminal of the loop filter 3a and the inverting input terminal of the operational amplifier 31. Both one end of the resistor Rₕ and one end of the capacitor Cₕₛ are connected to the inverting input terminal of the operational amplifier 31, and the resistor Rₕ and the capacitor Cₕₛ are connected in parallel. The parallel circuit of the resistor Rₕ and the capacitor Cₕₛ is connected to the output terminal of the operational amplifier 31 through the capacitor cₕ, namely, the output terminal of the loop filter 3a. In other words, the resistor Rₕ and the capacitors Cₕₛ, Cₕ constitute the feedback circuit of the operational amplifier 31. The high-speed time constant circuit 32 constituted by the feedback circuit and the input resistor R together with the operational amplifier 31 constitutes one loop filter. The time constant of the loop filter is determined by the time constant of the high-speed time constant circuit 32. In this embodiment, the time constant of the high-speed time constant circuit 32 is set at a small value which is suitable for high-speed pulling at the time of switching the output frequency f₀.

The low-speed time constant circuit 33 is composed of the resistor R, a resistor Rₐ, capacitors Cₐₛ and Cₐ. The resistor Rₐ and the capacitor Cₐₛ are connected in parallel with each one end connected to the inverting input terminal of the operational amplifier 31 and each of the other ends is connected to the output terminal of the operational amplifier 31 via the capacitor Cₐ and a switch Sₐ. While the switch Sₐ is closed and a switch S_{b} is opened, the low-speed time constant circuit 33 and the operational amplifier 31, together with the high-speed time constant circuit 32, constitute one loop filter. The time constant of the loop filter is mainly determined by the time constant of the low-speed time constant circuit 33. In this embodiment, the time constant of the low-speed time constant circuit 33 is set at a value which is capable of stabilizing the output frequency f₀ by a frequency fₐ and suppressing a spurious output frequency.

The low-speed time constant circuit 34 is composed of the resistor R, a resistor R_{b}, capacitors C_{bs} and C_{b}. The resistor R_{b} and the capacitor C_{bs} are connected in parallel with each one end connected to the inverting input terminal of the operational amplifier 31 and each the other ends connected to the output terminal of the operational amplifier 31 via the capacitor C_{b} and the switch S_{b}. While the switch S_{b} is closed and the switch Sₐ is opened, the low-speed time constant circuit 34 and the operational amplifier 31 together with the high-speed time constant circuit 32 constitute one loop filter. The time constant of the loop filter is determined by the time constant of the low-speed time constant circuit 34. In this embodiment, the time constant of the low-speed time constant circuit 34 is set at a value which is capable of stabilizing the output frequency f₀ by a frequency f_{b} and favorably suppressing a spurious output frequency.

The controller 5a controls the switches Sₐ, S_{b} which constitute the loop filter 3a. The first embodiment is characterized by the structure of the loop filter 3a and the control process of the controller 5a.

### c) Comparative example

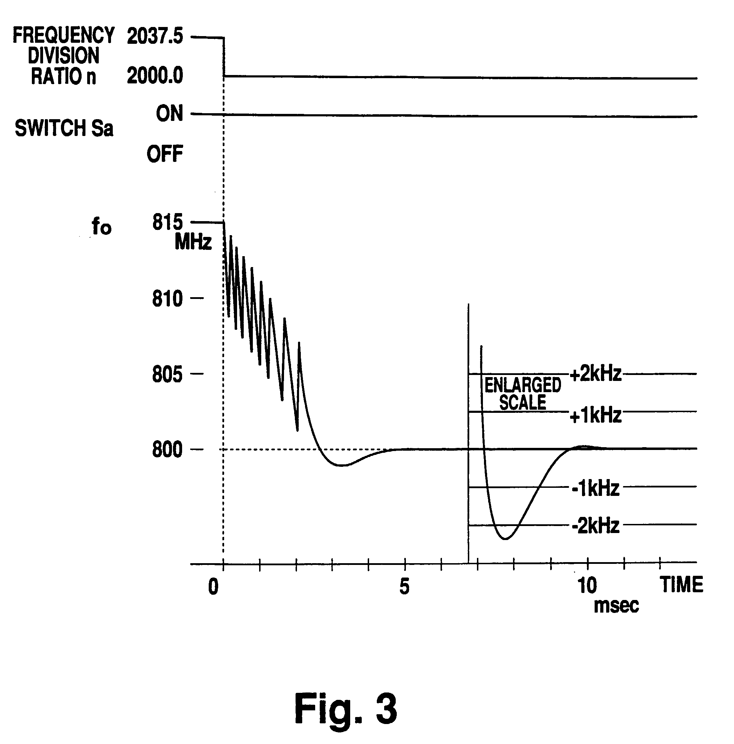

In order to clarify the advantages of particular embodiments of the present invention and the system for bringing about the advantages, a conventional control process is shown in Fig. 3 as a comparative example. Fig. 3 shows the frequency stabilizing operation when the output frequency is switched from f₀ to fₐ by controlling the frequency division ratio n of the variable frequency divider 1 while holding the switch Sₐ ON. In Fig. 3, it is assumed that fₐ = 815 MHz and f_{b} = 800 MHz, and that the frequency division ratio n which is necessary for controlling the output frequency f₀ to fₐ is 2037.5, and the frequency division ratio n which is necessary for controlling the output frequency f₀ to f_{b} is 2000.0.

As shown in Fig. 3, when the controller 5a changes the frequency division ratio n from 2037.7 to 2000.0 (time = 0) while holding the switch Sₐ ON, a long time is required for the output frequency f₀ to be switched from fₐ to f_{b}. To state this concretely, the time required for stabilizing the output frequency f₀ to the frequency f_{b} with an error of less than about 200 Hz is more than 8 msec. If such a long time is required for switching the output frequency f₀, a PLL synthesizer which is suitable for a local oscillator for digital QPSK demodulation is not realized, so that favorable demodulation is impossible.

### d) Process of switching a frequency

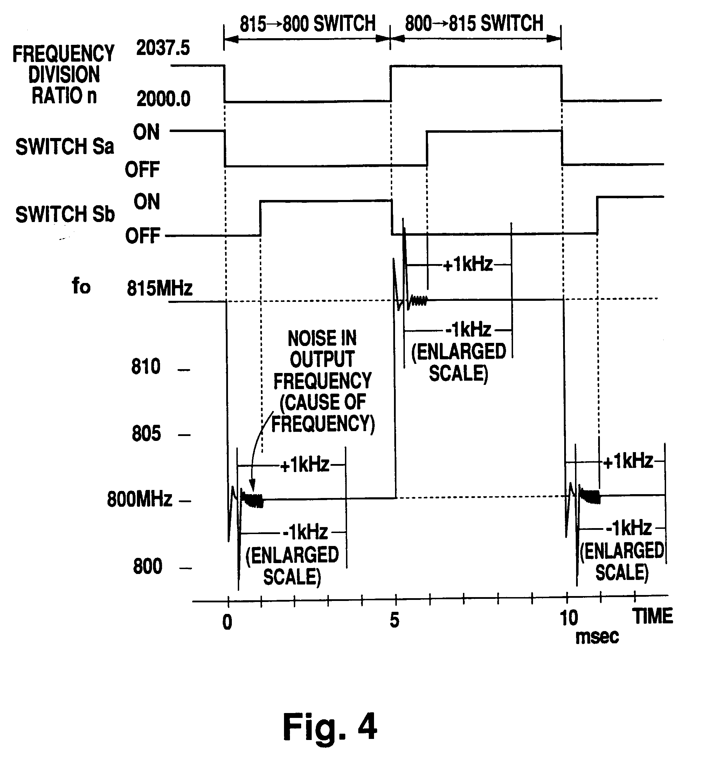

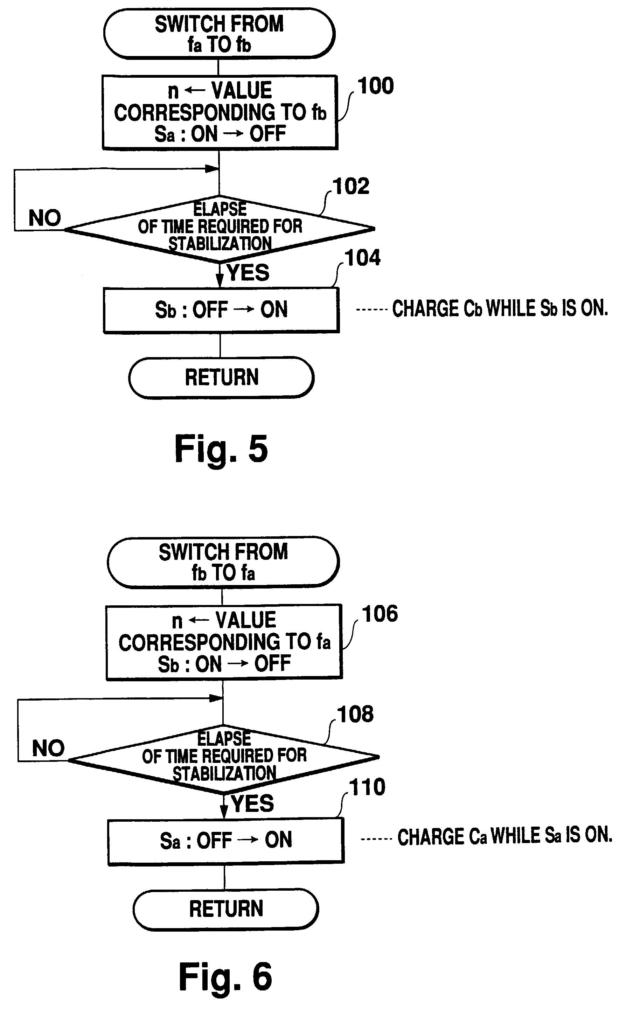

In this embodiment, the controller 5a exerts the control shown in Figs. 4 to 6 when the output frequency f₀ is switched from fₐ to f_{b} or vice versa. Fig. 4 shows the frequency stabilizing state at the time of switching a frequency, Fig. 5 shows the controlling process of the controller 5a when the frequency is switched from fₐ to f_{b}, and Fig. 6 shows the controlling process of the controller 5a when the frequency is switched from f_{b} to fₐ. In these drawings, it is also assumed that fₐ = 815 MHz and f_{b} = 800 MHz, and that the frequency division ratio n which is necessary for controlling the output frequency f₀ to fₐ is 2037.5, and the frequency division ratio n which is necessary for controlling the output frequency f₀ to f_{b} is 2000.0.

The case of switching the output frequency f₀ from fₐ to f_{b} (time = o) will first be considered. It is assumed that the output frequency f₀ has been controlled to the frequency f_{b} at a previous point in time. Due to this history, the charges necessary for stabilizing the output frequency f₀ at f_{b} are already stored in the capacitor C_{b} of the low-speed time constant circuit 34. It is also assumed that the switch Sₐ is ON and the switch S_{b} is OFF immediately before switching fₐ to f_{b}.

When the controller 5a switches the output frequency f₀ from fₐ to f_{b}, it first switches the frequency division ratio n of the variable frequency divider 1 from 2037.5, which corresponds to fₐ, to 2000.0. which corresponds to f_{b} (step 100 in Fig. 5). At the same time, the controller 5a turns off the switch Sₐ of the loop filter 3a (step 100). Since both the switches Sₐ and S_{b} are OFF, the time constant of the loop filter 3a becomes the time constant determined by the high-speed time constant circuit 32. With this time constant, the output frequency f₀ is changed at high speed. More specifically, switching of the frequency is completed in about 0.6 msec.

Immediately after the switching of the frequency, since the time constant is the value determined by the high-speed time constant circuit 32, a slight spurious output frequency is produced, as shown in Fig. 4. In order to suppress the spurious output frequency quickly in this embodiment, the controller 5a is turned on (step 104) at a predetermined point of time after the end of switching, namely, when the output frequency f₀ is sufficiently stabilized at the frequency f_{b} (step 102). The time constant of the loop filter 3a then becomes a time constant determined mainly by the low-speed time constant circuit 34. This is because the capacitor C_{b} which constitutes the low-speed time constant circuit 34 has a large capacitance than the capacitor Cₕ.

Consequently, by turning on the switch S_{b} with the timing shown in Fig. 4, the noise of the reference frequency fᵣ or the slip frequency caused by the divider 1 and, hence, the spurious output frequency are suppressed. The charges necessary for stabilizing the output frequency f₀ at f_{b} are already stored in the capacitor C_{b} while the switch S_{b} is ON. As a result, when the output frequency f₀ has been controlled to be the frequency f_{b} at a preceding point in time, as described above, by turning on the switch S_{b} with the timing shown in Fig. 4, the above-described advantages are produced without fluctuation of the output frequency f₀.

When the output frequency f₀ is switched from the frequency f_{b} to the frequency fₐ (the right half in Fig. 4, and Fig. 6), the switch S_{b} is turned off (step 106) in the state in which the switch S_{b} is ON, and after the output frequency f₀ is changed to the frequency fₐ (step 108), the switch Sₐ is turned on (step 110).

In this embodiment, the output frequency f₀ is switched between fₐ and f_{b}, but the number of output frequencies is not restricted to two. In the case of providing three different output frequencies for f₀, the number of low-speed time constant circuits provided is changed to three. Such modification will be easy to those skilled in the art by reference to the specification and the drawings of the present application.

This embodiment of the PLL synthesizer is used for a local oscillator for switching the local oscillation frequency (output frequency f₀ of the PLL synthesizer). Such an operation of switching the local oscillation frequency may be adopted not only when the the transmitted frequency or the received frequency is switched to a frequency in another channel but also when the transmitted frequency is switched to the received frequency or vice versa in a press-to-talk wireless installation.

It is because the reference frequency fᵣ is assumed to be 400 kHz that the frequency division ratio n of the variable frequency divider 1 is switched between 2037.5 and 2000.0 in this embodiment (815 MHz/400 kHz = 2037.5, 800 MHz/400 kHz = 2000.0). However, the reference frequency fᵣ may be set at any value, so that the frequency division ratio n of the variable frequency divider 1 may be set at any value.

### e) Process of monitoring a frequency

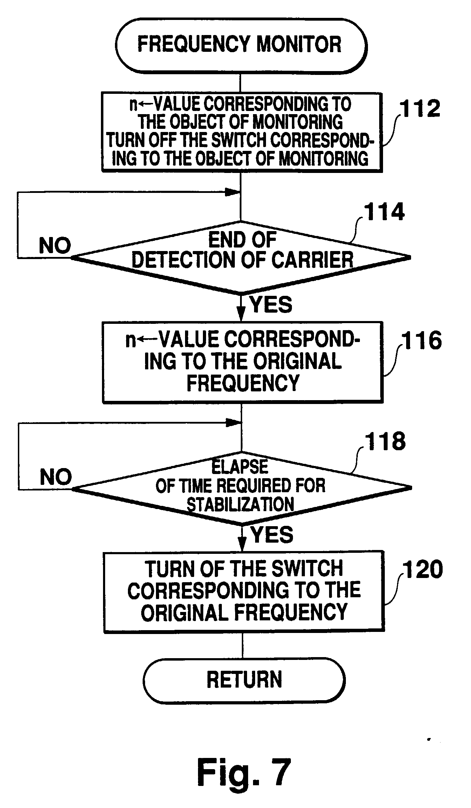

The present invention is not restricted to switching of a frequency. For example, the present invention is also applicable to monitoring of a frequency executed in a wireless installation for TDMA (Time Division Multiple Access) such as a digital portable phone. The monitoring of a frequency involves the processing of temporarily receiving another frequency during the communication at a certain frequency, for example, at the frequency f_{b} so as to judge whether or not a carrier of the frequency exists. Fig. 7 shows the control process of the controller 5a for executing the monitoring.

As shown in Fig. 7, the controller 5a first switches the frequency division ratio n of the variable frequency divider 1 to the value which corresponds to the frequency as the object of monitoring (step 112). At the same time, the controller 5a turns off the switch (e.g. S_{b}) which corresponds to the frequency at which communication has been established, thereby changing the time constant of the loop filter 3a to a comparatively small time constant which is determined by the high-speed time constant circuit 32 (step 112). After the detection of a carrier is finished by a circuit (not shown) at the subsequent stage, in other words, a predetermined monitoring period ends (step 114), the controller 5a switches the frequency division ratio n to the value (e.g., 2037.5) which corresponds to the original frequency (step 116). At the point of time where the time required for stabilization of the output frequency f₀ has elapsed (step 118), the controller 5a turns on the switch (e.g., S_{b}) which corresponds to the original frequency (step 120).

In this manner, it is possible to change the frequency to the frequency which is to be the object of monitoring at high speed. Since this frequency is used only for detection of a carrier and is not used for communication, the stabilization of the frequency with high accuracy, which is required in the communication of information such as voice, is not necessary. It is therefore not necessary to provide a low-speed time constant circuit for stabilizing the output frequency f₀ which is the object of monitoring.

At the time of commencing communication after the end of the detection of a carrier, the frequency is stabilized in a short time by high-frequency changing and thereafter the low-speed time constant circuit is energized so as to suppress a spurious output frequency. This operation enables high-speed changing for the purpose of communication and favorable suppression of a spurious output frequency.

### f) Structure of the loop filter 3b in a second embodiment

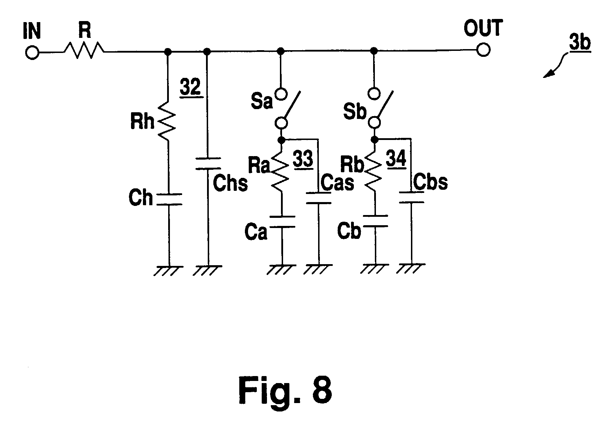

Fig. 8 shows the structure of the main part of a second embodiment of a PLL synthesizer of the present invention. In Fig. 8, a loop filter 3b is used in place of the loop filter 3a shown in Fig. 1. The loop filter 3b is different from the loop filter 3a in that it is a lag lead type. When the control shown in Fig. 4 is exerted by the second embodiment having this structure, the effects of high-speed output frequency f₀ changing and the suppression of a spurious output frequency are brought about in the same way as by the first embodiment.

### g) Advantages of the embodiments

As explained above, in each of the embodiments, the high-speed time constant circuit 32 and the low-speed time constant circuits 33, 34 are provided in the loop filter 3a or 3b, and the low-speed time constant circuits 33 and 34 are appropriately inserted in a circuit by using the switches Sa and Sb. Therefore, the PLL synthesizer which is suitable for monitoring a frequency and switching of the output frequency f₀ is obtained by using an A/D converter or a D/A converter having high accuracy. It is possible to increase the speed of switching or a frequency by using the high-speed time constant circuit 32 and to favorably suppress a spurious output frequency by using the low-speed time constant circuits 33 and 34 after switching of the output frequency f₀. For example, even if the output frequency f₀ is switched with a difference of about 15 MHz, it is possible to stabilize the output frequency f₀ with an error of less than about 200 Hz in about 1 m sec, thereby enabling digital QPSK demodulation. A spurious output frequency produced due to an error of the reference frequency fᵣ which is supplied to the detector or the slip frequency caused by the division using the ratio n down to a value smaller than one. As a result, it is possible to produce a PLL synthesizer which is suitable for a press-to-talk wireless installation, a digital cellular telephone, a digital cordless telephone, etc., and which has a small size at a low cost.

In each of these embodiments, the resistor R is shared by the high-speed time constant circuit 32 and the low-speed time constant circuits 33 and 34. This comparatively simplifies the structure of the apparatus.

While there has been described what are at present considered to be preferred embodiments of the invention, it will be understood that various modifications may be made thereto, and it is intended that the appended claims cover all such modifications as fall within the scope of the invention.

## Claims

1. A phase locked loop synthesizer comprising:
an oscillator (4) for oscillating at an output frequency which depends upon a control voltage supplied thereto;
a frequency divider (1) for dividing the output frequency in correspondence with a required output frequency;
a detector (2) for detecting a phase of a frequency-divided output frequency by referring to a reference frequency which is the reference of the output frequency so as to produce the control voltage; and
a loop filter (3a, 3b) for stabilizing the output frequency by filtering the control voltage produced by said detector (2) and supplying a filtered control voltage to said oscillator (4),
said loop filter (3a, 3b) including;
a high-speed time constant circuit (32) constantly inserted between said detector (2) and said oscillator (4) and having a predetermined first time constant so set that when the required output frequency is changed, the output frequency produced by said oscillator is stepwisely changed to a new output frequency at high speed;
a low-speed time constant circuit (33,34) including a capacitor, said low-speed time constant circuit being inserted between said detector (2) and said oscillator (4) as occasion demands and having a predetermined second time constant so set that a spurious output frequency produced due to an error of the reference frequency or an error of the frequency-divided output frequency is suppressed when the low-speed time constant circuit (33, 34) is inserted between said detector and said oscillator; and
switching means for making and breaking a signal path between said detector (2) and said oscillator (4) via said low-speed time constant circuit (33, 34) as occasion demands, characterised in that:
while said low-speed time constant circuit is not inserted between said detector and said oscillator, said capacitor holds a voltage indicative of the frequency at which said oscillator was oscillating when said low-speed time constant circuit was last inserted between said detector and said oscillator.

2. A synthesizer according to claim 1, for providing a plurality of output frequencies (fₐ, f_{b}), said plurality of output frequencies including at least a first frequency and a second frequency, the synthesizer further comprising:
a plurality of circuits arranged in parallel, each circuit comprising a low-speed time constant circuit (33,34) in series with switching means (Sₐ,S_{b}), each said circuit being provided in correspondence with a respective one of said plurality of output frequencies; and
a controller (5a) for controlling the frequency divider (1) and said switching means (Sₐ, S_{b}) in accordance with a predetermined processing,
said controller (5a) including:
means for switching the output frequency (f₀) from the first frequency to the second frequency by controlling said frequency divider (1);
means for breaking the signal path between the said detector (2) and said oscillator (4) via said low-speed time constant circuit (33) which corresponds to the first frequency by controlling said switching means which corresponds to the first frequency when the output frequency (f₀) is to be switched from the first frequency to the second frequency; and
means for making the signal path between said detector (2) and said oscillator (4) via said low-speed time constant circuit (34) which corresponds to the second frequency by controlling said switching means which corresponds to the second frequency after the output frequency (f₀) is changed in a stepwise manner to the second frequency.

3. A synthesizer according to claim 1, further comprising a controller (5a) for controlling said frequency divider (1) and said switching means (Sₐ, S_{b}) in accordance with predetermined processing, said controller (5a) including:
means for switching a frequency division ratio of said frequency divider (1) to the value which corresponds to a temporary frequency when the output frequency f₀ is to be temporarily switched from a communication frequency to the temporary frequency;
means for switching the time constant of said loop filter (3a, 3b) to a value smaller than a usual value by controlling said switching means when the output frequency (f₀) is to be temporarily switched from the communication frequency to the temporary frequency ;
means for switching the frequency division ratio (n) of said frequency divider (1) to a value which corresponds to the communication frequency when the output frequency (f₀) is to be returned to the communication frequency; and
means for switching the time constant of said loop filter (3a, 3b) to a value which corresponds to the communication frequency and which is suitable for suppressing a spurious output frequency by controlling said switching means after the output frequency (f₀) is returned to the communication frequency.

4. A synthesizer according to claim 1, for preparing a plurality of output frequencies (fₐ,f_{b}), the synthesizer further comprising:
a plurality of circuits arranged in parallel, each circuit comprising a low-speed time constant circuit (33,34) in series with switching means (Sₐ, S_{b}), each said circuit being provided in correspondence with a respective one of said plurality of output frequencies (f_{a,}f_{b}), each of said low-speed time constant circuits (33,34) including a resistor (R, Rₐ, R_{b}) and a capacitor (Cₐ, Cₐₛ, C_{b}, C_{bs}) connected in series, and
at least one of said resistors (R, Rₐ, R_{b}) being shared by at least two of said low-speed time constant circuits (34,33).

## Patentansprüche

1. Synthetisierer mit Phasenverriegelungsschleife, umfassend:
- einen Oszillator (4) zum Oszillieren mit einer Ausgangsfrequenz, welche von einer ihm zugeführten Steuerspannung abhängt,
- einen Frequenzteiler (1) zum Teilen der Ausgangsfrequenz in Übereinstimmung mit einer benötigten Ausgangsfrequenz,
- einen Detektor (2) zum Detektieren einer Phase einer frequenzgeteilten Ausgangsfrequenz durch Bezugnahme auf eine Referenzfrequenz, die die Referenz der Ausgangsfrequenz ist, um die Steuerspannung zu erzeugen, und
- ein Schleifenfilter (3a, 3b) zum Stabilisieren der Ausgangsfrequenz durch Filtern der von dem Detektor (2) erzeugten Steuerspannung und Zuführen einer gefilterten Steuerspannung zu dem Oszillator (4),
wobei das Schleifenfilter (3a, 3b) umfaßt:
- eine Hochgeschwindigkeits-Zeitkonstantenschaltung (32), die dauerhaft zwischen den Detektor (2) und den Oszillator (4) eingefügt ist und eine vorbestimmte erste Zeitkonstante besitzt, die so eingestellt ist, daß die von dem Oszillator erzeugte Ausgangsfrequenz mit hoher Geschwindigkeit schrittweise auf eine neue Ausgangsfrequenz geändert wird, wenn die benötigte Ausgangsfrequenz geändert wird,
- eine Niedergeschwindigkeits-Zeitkonstantenschaltung (33, 34) mit einer Kapazität, wobei die Niedergeschwindigkeits-Zeitkonstantenschaltung zwischen den Detektor (2) und den Oszillator (4) bedarfsweise eingefügt ist und eine vorbestimmte zweite Zeitkonstante besitzt, die so eingestellt ist, daß eine aufgrund eines Fehlers der Referenzfrequenz oder eines Fehlers der frequenzgeteilten Ausgangsfrequenz erzeugte Störausgangsfrequenz unterdrückt wird, wenn die Niedergeschwindigkeits-Zeitkonstantenschaltung (33, 34) zwischen den Detektor und den Oszillator eingefügt ist, und
- Schaltmittel zum bedarfsweisen Herstellen und Unterbrechen eines Signalwegs zwischen dem Detektor (2) und dem Oszillator (4) über die Niedergeschwindigkeits-Zeitkonstantenschaltung (33, 34),
dadurch gekennzeichnet, daß bei nicht zwischen den Detektor und den Oszillator eingefügter Niedergeschwindigkeits-Zeitkonstantenschaltung die Kapazität eine Spannung hält, die die Frequenz angibt, mit der der Oszillator oszilliert hat, als die Niedergeschwindigkeits-Zeitkonstantenschaltung zuletzt zwischen den Detektor und den Oszillator eingefügt war.

2. Synthetisierer nach Anspruch 1, zur Bereitstellung einer Mehrzahl von Ausgangsfrequenzen (fₐ, f_{b}), wobei diese Mehrzahl von Ausgangsfrequenzen zumindest eine erste Frequenz und eine zweite Frequenz umfaßt, wobei der Synthetisierer ferner umfaßt:
- eine Mehrzahl von parallel angeordneten Schaltkreisen, wobei jeder Schaltkreis eine Niedergeschwindigkeits-Zeitkonstantenschaltung (33, 34) in Reihe mit Schaltmitteln (Sₐ, S_{b}) umfaßt, wobei jeder Schaltkreis in Übereinstimmung mit einer jeweiligen der Mehrzahl von Ausgangsfrequenzen vorgesehen ist, und
- eine Steuereinheit (5a) zum Steuern des Frequenzteilers (1) und der Schaltmittel (Sₐ, S_{b}) nach Maßgabe eines vorbestimmten Prozesses,
wobei die Steuereinheit (5a) umfaßt:
- Mittel zum Umschalten der Ausgangsfrequenz (f₀) von der ersten Frequenz auf die zweite Frequenz durch Steuerung des Frequenzteilers (1),
- Mittel zum Unterbrechen des Signalwegs zwischen dem Detektor (2) und dem Oszillator (4) über die Niedergeschwindigkeits-Zeitkonstantenschaltung (33), die der ersten Frequenz entspricht, durch Steuerung der Schaltmittel, die der ersten Frequenz entsprechen, wenn die Ausgangsfrequenz von der ersten Frequenz auf die zweite Frequenz umzuschalten ist, und
- Mittel zum Herstellen des Signalwegs zwischen dem Detektor (2) und dem Oszillator (4) über die Niedergeschwindigkeits-Zeitkonstantenschaltung (34), die der zweiten Frequenz entspricht, durch Steuerung der Schaltmittel, die der zweiten Frequenz entsprechen, nachdem sich die Ausgangsfrequenz (f₀) schrittweise auf die zweite Frequenz geändert hat.

3. Synthetisierer nach Anspruch 1, ferner umfassend eine Steuereinheit (5a) zum Steuern des Frequenzteilers (1) und der Schaltmittel (Sₐ, S_{b}) nach Maßgabe eines vorbestimmten Prozesses, wobei die Steuereinheit (5a) umfaßt:
- Mittel zum Umschalten eines Frequenzteilungsverhältnisses des Frequenzteilers (1) auf den Wert, der einer zeitweiligen Frequenz entspricht, wenn die Ausgangsfrequenz (f₀) zeitweilig von einer Kommunikationsfrequenz auf die zeitweilige Frequenz umzuschalten ist,
- Mittel zum Umschalten der Zeitkonstante des Schleifenfilters (3a, 3b) auf einen Wert, der kleiner als ein üblicher Wert ist, durch Steuerung der Schaltmittel, wenn die Ausgangsfrequenz (f₀) zeitweilig von der Kommunikationsfrequenz auf die zeitweilige Frequenz umzuschalten ist,
- Mittel zum Umschalten des Frequenzteilungsverhältnisses (n) des Frequenzteilers (1) auf einen Wert, der der Kommunikationsfrequenz entspricht, wenn die Ausgangsfrequenz (f₀) auf die Kommunikationsfrequenz zurückzustellen ist, und
- Mittel zum Umschalten der Zeitkonstante des Schleifenfilters (3a, 3b) auf einen Wert, der der Kommunikationsfrequenz entspricht und der zur Unterdrückung einer Störausgangsfrequenz geeignet ist, durch Steuerung der Schaltmittel, nachdem die Ausgangsfrequenz (f₀) auf die Kommunikationsfrequenz zurückgestellt ist.

4. Synthetisierer nach Anspruch 1, zur Bereitstellung einer Mehrzahl von Ausgangsfrequenzen (fₐ, f_{b}), wobei der Synthetisierer ferner umfaßt:
- eine Mehrzahl von parallel angeordneten Schaltkreisen, wobei jeder Schaltkreis eine Niedergeschwindigkeits-Zeitkonstantenschaltung (33, 34) in Reihe mit Schaltmitteln (Sₐ, S_{b}) umfaßt, wobei jeder Schaltkreis in Übereinstimmung mit einer jeweiligen der Mehrzahl von Ausgangsfrequenzen (fₐ, f_{b}) vorgesehen ist, wobei jede der Niedergeschwindigkeits-Zeitkonstantenschaltungen (33, 34) einen Widerstand (R, Rₐ, R_{b}) und eine Kapazität (Cₐ, Cₐₛ, C_{b}, C_{bs}) umfaßt, die in Reihe geschaltet sind, wobei mindestens einer der Widerstände (R, Rₐ, R_{b}) mindestens zweien der Niedergeschwindigkeits-Zeitkonstantenschaltungen (34, 33) zugehörig ist.

## Revendications

1. Synthétiseur à boucle à phase asservie comprenant :
un oscillateur (4) oscillant à une fréquence de sortie qui dépend d'une tension de commande délivrée à ce dernier ;
un diviseur de fréquence (1) pour diviser la fréquence de sortie en correspondance avec une fréquence de sortie demandée ;
un détecteur (2) pour détecter une phase d'une fréquence de sortie à fréquence divisée en se référant à une fréquence de référence qui est la référence de la fréquence de sortie de façon à produire la tension de commande ; et
un filtre en boucle (3a, 3b) pour stabiliser la fréquence de sortie en filtrant la tension de commande produite par ledit détecteur (2) et en délivrant une tension de commande filtrée audit oscillateur (4),
ledit filtre en boucle (3a, 3b) comprenant :
un circuit à constante de temps à haute vitesse (32) inséré en permanence entre ledit détecteur (2) et ledit oscillateur (4) et ayant une première constante de temps prédéterminée fixée de sorte que lorsque la fréquence de sortie demandée est modifiée, la fréquence de sortie produite par ledit oscillateur est modifiée par étapes jusqu'à une nouvelle fréquence de sortie à haute vitesse ;
un circuit à constante de temps à basse vitesse (33, 34) incluant un condensateur, ledit circuit à constante de temps à basse vitesse étant inséré entre ledit détecteur (2) et ledit oscillateur (4) lorsque les circonstances le demandent, et ayant une seconde constante de temps prédéterminée fixée de sorte qu'une fréquence de sortie parasite produite en raison d'une erreur de la fréquence de référence ou d'une erreur de la fréquence de sortie à fréquence divisée est supprimée lorsque le circuit à constante de temps à basse vitesse (33, 34) est inséré entre ledit détecteur et ledit oscillateur ; et
des moyens de commutation pour établir et couper un chemin de signal entre ledit détecteur (2) et ledit oscillateur (4) par l'intermédiaire dudit circuit à constante de temps à basse vitesse (33, 34) lorsque les circonstances le demandent, caractérisé en ce que :
tandis que ledit circuit à constante de temps à basse vitesse n'est pas inséré entre ledit détecteur et ledit oscillateur, ledit condensateur retient une tension indicative de la fréquence à laquelle ledit oscillateur oscillait lorsque ledit circuit à constante de temps à faible vitesse était inséré en dernier lieu entre ledit détecteur et ledit oscillateur.

2. Synthétiseur selon la revendication 1, réalisant une pluralité de fréquences de sortie (fₐ, f_{b}), ladite pluralité de fréquences de sortie incluant au moins une première fréquence et une seconde fréquence, le synthétiseur comprenant de plus :
une pluralité de circuits agencés en parallèle, chaque circuit comprenant un circuit à constante de temps à faible vitesse (33, 34) en série avec des moyens de commutation (Sₐ, S_{b}), chaque dit circuit étant réalisé en correspondance avec une fréquence respective de ladite pluralité de fréquences de sortie ; et
une unité de commande (5a) pour commander le diviseur de fréquence (1) et lesdits moyens de commutation (Sₐ, S_{b}) selon un traitement prédéterminé,
ladite unité de commande (5a) comprenant :
des moyens pour commuter la fréquence de sortie (f₀) de la première fréquence vers la seconde fréquence en commandant ledit diviseur de fréquence (1) ;
des moyens pour couper le chemin de signal entre ledit détecteur (2) et ledit oscillateur (4) par l'intermédiaire dudit circuit à constante de temps à faible vitesse (33) qui correspond à la première fréquence en commandant lesdits moyens de commutation qui correspondent à la première fréquence lorsque la fréquence de sortie (f₀) est à commuter de la première fréquence vers la seconde fréquence ; et
des moyens pour établir le chemin de signal entre ledit détecteur (2) et ledit oscillateur (4) par l'intermédiaire dudit circuit à constante de temps à faible vitesse (34) qui correspond à la seconde fréquence en commandant lesdits moyens de commutation qui correspondent à la seconde fréquence après que la fréquence de sortie (f₀) a été modifiée par étapes jusqu'à la seconde fréquence.

3. Synthétiseur selon la revendication 1, comprenant, de plus, une unité de commande (5a) pour commander ledit diviseur de fréquence (1) et lesdits moyens de commutation (Sₐ, S_{b}) selon un traitement prédéterminé, ladite unité de commande (5a) incluant :
des moyens pour commuter un rapport de division de fréquence dudit diviseur de fréquence (1) à la valeur qui correspond à une fréquence temporaire lorsque la fréquence de sortie (f₀) est à commuter, de façon temporaire, depuis une fréquence de communication jusqu'à la fréquence temporaire ;
des moyens pour commuter la constante de temps dudit filtre en boucle (3a, 3b) à une valeur plus petite qu'une valeur habituelle en commandant lesdits moyens de commutation lorsque la fréquence de sortie (f₀) est à commuter, de façon temporaire, de la fréquence de communication à la fréquence temporaire ;
des moyens pour commuter le rapport de division de fréquence (n) dudit diviseur de fréquence (1) vers une valeur qui correspond à la fréquence de communication lorsque la fréquence de sortie (f₀) doit revenir à la fréquence de communication ; et
des moyens pour commuter la constante de temps dudit filtre en boucle (3a, 3b) vers une valeur qui correspond à la fréquence de communication et qui sont appropriés pour supprimer une fréquence de sortie parasite en commandant lesdits moyens de commutation après que la fréquence de sortie (f₀) a été ramenée à la fréquence de communication.

4. Synthétiseur selon la revendication 1, pour préparer une pluralité de fréquences de sortie (fₐ, f_{b}), le synthétiseur comprenant de plus :
une pluralité de circuits agencés en parallèle, chaque circuit comprenant un circuit à constante de temps à basse vitesse (33, 34) en série avec des moyens de commutation (Sₐ, S_{b}), chaque dit circuit étant réalisé en correspondance avec une fréquence respective de ladite pluralité de fréquences de sortie (fₐ, f_{b}), chacun desdits circuits à constante de temps à basse vitesse (33, 34) incluant une résistance (R, Rₐ, R_{b}) et un condensateur (Ca, Cₐₛ, C_{b}, C_{bs}) reliés en série, et
au moins une desdites résistances (R, Rₐ, R_{b}) étant partagée par au moins deux desdits circuits à constante de temps à faible vitesse (34, 33).
